Europäisches Patentamt

European Patent Office

Office européen des brevets

(19)

(11) Veröffentlichungsnummer: **0 395 961**

**A1**

(12) # EUROPÄISCHE PATENTANMELDUNG

(21) Anmeldenummer: **90107564.8**

(22) Anmeldetag: **20.04.90**

(51) Int. Cl.5: **H05K 3/10, G03F 7/28**

(30) Priorität: **21.04.89 DE 3913117**

(43) Veröffentlichungstag der Anmeldung:
**07.11.90 Patentblatt 90/45**

(84) Benannte Vertragsstaaten:
**CH DE ES FR GB IT LI NL SE**

(71) Anmelder: **DU PONT DE NEMOURS
(DEUTSCHLAND) GMBH
Du Pont Strasse 1
D-6380 Bad Homburg(DE)**

(72) Erfinder: **Dudek, Dietmar, Dr.
Uhlandstrasse 11
D-6070 Langen(DE)**
Erfinder: **Pfeiffer, Thomas, Dr.
25 Glenbarry Drive
Wilmington, Delaware 19808(US)**

(54) **Verfahren zur Herstellung von elektrisch leitfähigen Mustern.**

(57)

2.1. Die Herstellung von Leiterbahnmustern auf keramischen Substraten nach dem Pulververfahren erfordert spezielle Pulver, welche die für die Steuerung der Haftung und des Sintervorgangs notwendigen Zusatzelemente enthalten. Die Herstellung dieser Pulver ist kompliziert ist und ihre Zusammensetzung kann sich beim Auftragen verändern. Es soll ein Verfahren angegeben werden, welches die Verwendung handelsüblicher Pulver, die nur aus den Leitmetallen bestehen, ermöglicht.

2.2. Das keramische Substrat wird vor der Ausführung des Pulververfahrens mit einer Lösung von Salzen beschichtet, welche die Zusatzelemente enthalten, getrocknet, und einer Wärmebehandlung bei einer Temperatur unterzogen, welche niedriger ist als die zur Bildung der Oxide aus den Salzen erforderliche Temperatur.

2.3. Herstellung gedruckter Schaltungen auf keramischen Substraten, beispielsweise für Hybridschaltkreise.

EP 0 395 961 A1

# Verfahren zur Herstellung von elektrisch leitfähigen Mustern

Die Erfindung betrifft ein Verfahren zur Herstellung von elektrisch leitfähigen Mustern auf keramischen Substraten, wie sie beispielsweise als elektrische Schaltkreise in Hybridanordnungen verwendet werden.

Aus der deutschen Auslegeschrift 11 07 743 und der kanadischen Patentschrift 11 55 967 ist bekannt, elektrisch leitfähige Muster auf der Oberfläche von keramischen Substraten nach dem sog. Pulververfahren herzustellen. Dabei wird auf der Oberfläche des Substrates ein klebriges Muster erzeugt und danach die Oberfläche mit einem metallhaltigen Pulver behandelt. Durch eine Wärmebehandlung kann dann das klebrige Material entfernt und das Metallpulver zu einem zusammenhängenden Muster von Leiterbahnen gesintert werden.

Im allgemeinen ist es notwendig, daß neben dem eigentlichen Leitmetall, aus dem die Leiterbahnen gebildet werden, in dem System noch weitere Zusatzelemente, ggf. in Form geeigneter Verbindungen, zugegen sind, um die Haftung der gemusterten Metallschicht auf dem Substrat nach dem Sintern zu ermöglichen und um den Sintervorgang so zu steuern, daß Leiterbahnen mit glatter Oberfläche und gleichmäßigem Querschnitt entstehen. Man unterscheidet zwei Mechanismen für das Zustandekommen der Haftung. Bei der Glasbindung bilden die Oxide der Zusatzelemente ein Glas, welches bei der Brenntemperatur schmilzt und das Substrat mit der Leiterbahn nach dem Erkalten teils durch Adhäsion, teils durch Formschluß verbindet, während bei der reaktiven oder Oxidbindung durch Festkörperreaktion dieser Oxide mit Substrat und Leitmetall eine bindende Zwischenphase entsteht. Die Auswahl der Zusatzelemente richtet sich dementsprechend nach dem Leitmetall und nach der Art des Substrats. Geeignete Kombinationen sind aus der Dickfilmtechnik bekannt. Beispielsweise sind in der deutschen Patentschrift 25 43 922 haftvermittelnde Verbindungen für Gold und Silber auf Aluminiumoxid, Berylliumoxid und Saphir genannt, die Cadmium, Kupfer, Blei, Titan, Zirkonium, Silicium, Bor und Alkalimetalle enthalten. Es ist auch bekannt, dekorative Goldüberzüge auf keramischen Substraten durch Verbindungen von Rhodium, Wismut und Silber so zu modifizieren, daß beim Sintern gleichmäßige Schichten mit guter Haftung und glänzender Oberfläche entstehen (s. z.B. Ullmann's Enzyklopädie der technischen Chemie, 4. Auflage, Band 14, Seite 10).

Die Zusatzelemente sollen demnach ihre Wirkung hauptsächlich an der Grenzfläche zwischen Substrat und Leitmetall bzw. an der Oberfläche des Leitmetalls entfalten. Es ist im allgemeinen nachteilig, wenn sie in das Leitmetall eindringen und mit diesem Mischungen bilden, weil dadurch die spezifische Leitfähigkeit in der Leiterbahn herabgesetzt wird.

In der deutschen Patentanmeldung 38 06 515 wird ein Verfahren beschrieben, mit dem man Metallpulver für das Pulververfahren herstellen kann, welche geeignete Verbindungen der erforderlichen Zusatzelemente in homogener Verteilung enthalten. Durch Verwendung der so gewonnenen Pulver lassen sich zwar feine Leiterbahnen guter Beschaffenheit und Leitfähigkeit herstellen. Das Herstellungsverfahren für die Pulver ist jedoch relativ kompliziert. Es ist auch nachteilig, daß für verschieden beschaffene Substrate und je nach der angestrebten Beschaffenheit der Leiterbahnen verschiedene Pulver hergestellt und vorrätig gehalten werden müssen.

In der europäischen Patentanmeldung 01 82 128 wird beschrieben, daß zur Verbesserung der Haftung dünner Metallfilme auf einer Oxidkeramik die letztere vor dem Aufsputtern des Metallfilms mit einer Metalloxidzwischenschicht versehen wird. Diese Oxidzwischenschicht wird durch Zersetzen einer Beschichtung mit einer geeigneten Metallverbindung bei hohen Temperaturen erzeugt. Wenn man jedoch auf einer solchen Oxidzwischenschicht ein leitfähiges Muster nach dem Pulververfahren erzeugt, dann ist die Haftung dieses Musters auf der Oxidkeramik ungenügend.

Die Erfindung stellt sich daher die Aufgabe, ein Verfahren anzugeben, nach dem sich auf einfache Weise die für die Herstellung von elektrisch leitfähigen Mustern auf keramischen Substraten nach dem Pulverfahren für die Steuerung der Haftung und des Sinterungsvorgangs notwendigen Zusatzelemente so in das System einbringen lassen, daß sie zuverlässig wirken und die Leitfähigkeit des Leitmetalls nicht beeinträchtigen.

Diese Aufgabe wird durch ein Verfahren nach Anspruch 1 gelöst.

Grundsätzlich eignen sich zur Ausführung des Verfahrens Salze jeder Art. Die Zusatzelemente können dabei sowohl im Kation als auch im Anion des Salzes enthalten sein. Haben die Zusatzelemente Metallcharakter, dann werden einfache Salze bevorzugt; insbesondere Acetate, Nitrate oder Chloride dieser Metalle. Andererseits kommen aber auch Salze in Frage, die ein nichtmetallisches Zusatzelement, beispielsweise Phosphor oder Bor, in Form eines Komplexanions enthalten. Bevorzugte Salze dieser Art sind Borate, insbesondere Alkaliborate.

Durch die erfindungsgemäße Behandlung des Substrats wird auf dessen Oberfläche eine Schicht erzeugt, die weder lediglich aus den getrockneten Salzkomponenten der zur Beschichtung verwendeten Lösung noch aus den beim Glühen aus diesen Salzen entstehenden Oxiden der Zusatzelemente besteht. Es wurde beobachtet, daß beim Trocknen zunächst eine mikrokristalline Schicht entsteht, die schlecht auf dem Substrat haftet und eine rauhe Oberfläche besitzt. Wenn man auf einer solchen Schicht eine lichtempfindliche Beschichtung aufbringt, dann wird diese sehr ungleichmäßig und überdies besteht die Gefahr, daß sich dabei einzelne Salzkristalle vom Substrat ablösen und Punktfehler in der lichtempfindlichen Schicht hervorrufen. Infolgedessen sind die mit einer solchen Schicht nach dem Pulververfahren hergestellten Leiterbahnmuster ebenfalls fehlerhaft. Andererseits ist, wie bereits erwähnt, die Haftung der Leiterbahnen am Substrat ungenügend, wenn man das Substrat vor dem Auftragen der lichtempfindlichen Beschichtung so stark erhitzt, daß die Oxide der Zusatzelemente entstehen.

Warum das erfindungsgemäße Verfahren bessere Ergebnisse liefert als die Vorbeschichtung der Substrate mit Oxiden nach dem Stand der Technik oder die naheliegende Erzeugung einer Salzschicht vor dem Auftragen der lichtempfindlichen Schicht kann nicht genau erklärt werden. Es wird angenommen, daß bei der Wärmebehandlung wenigstens ein Teil der aufgetragenen Salze durch Abspaltung von physikalisch oder chemisch gebundenem Wasser oder durch Umwandlung in basische Salze in einen Zwischenzustand überführt wird, der einerseits besser am Substrat haftet als die getrockneten Salze, andererseits aber beim späteren Sintern des Pulverbildes noch weiter reagiert, wobei die Zusatzelemente so beweglich werden, daß sie die Haftung zum Substrat herstellen und die Sinterung in der gewünschten Weise beeinflussen können. In gewissen Fällen läßt sich das Auftreten solcher Zwischenzustände bei der Wärmebehandlung der Salze durch physikalisch-chemische Methoden, z.B. Thermoanalyse, nachweisen. Besonders vorteilhaft ist es, wenn dieser Zwischenzustand in Form einer homogenen glasartigen Schicht auftritt. Dies läßt sich durch geeignete Auswahl der Salze erreichen.

Die Auswahl der Zusatzelemente richtet sich nach der Art der für den Aufbau der metallischen Muster verwendeten Metalle und nach der Art des Substrats. Der Fachmann kann hierzu den Stand der Technik sowie seine Erfahrungen auf dem Gebiet der Dickfilmtechnik heranziehen.

Besonders bevorzugte Leitmetalle für die Erzeugung der Leiterbahnmuster sind Gold, Silber, Platin, Palladium oder Kupfer. Diese Metalle werden als Pulver mit einer mittleren Teilchengröße von 0,1 bis 5 $\mu$m in reiner Form oder auch als Gemisch oder als Pulver ihrer Legierungen angewendet.

Wärmebeständige Substrate sind, dem derzeitigen Stand der Technik entsprechend, bevorzugt Formkörper aus Aluminiumoxid. Es können jedoch auch andere bekannte Substrate, beispielsweise aus Berylliumoxid, Aluminiumnitrid, Siliciumdioxid oder emailliertem Metall, Anwendung finden.

Als Zusatzelemente zur Steuerung der Haftung und des Sinterns sind insbesondere Blei, Rhodium, Nickel, Aluminium, Cadmium, Indium, Kupfer, Wismut und/oder Bor geeignet. Die Haftung kann also sowohl nach dem Mechanismus der Oxidbindung als auch nach dem der Glasbindung eingestellt werden.

Für die Erzeugung des wenigstens zeitweise klebrigen Musters auf dem Substrat kann beispielsweise ein geeigneter Klebstoff dienen, der mittels Siebdruck auf die Substratoberfläche, die mit der die Zusatzelemente enthaltenden Schicht versehen wurde, aufgebracht wird. Wegen des höheren Auflösungsvermögens und der daraus resultierenden wesentlich höheren Feinheit der metallischen Muster wird jedoch bevorzugt eine lichtempfindliche Schicht verwendet, deren Klebrigkeit sich bei Belichtung ändert. Geeignete Verbindungen sind in den deutschen Patentschriften 12 10 321, 19 04 059, 19 44 311, 27 28 209, 28 15 894, 30 23 247, 34 29 615 und anderen beschrieben. Besonders bevorzugt als lichtempfindliche Schichtkomponenten sind 1,4-Dihydropyridinverbindungen nach der DE-PS 34 29 615.

Die verwendeten Pulver sind vorzugsweise reine Pulver der für den Aufbau der Leiterbahnmuster ausgewählten Metalle oder Legierungen. Anstelle von Legierungen können selbstverständlich auch Gemische der entsprechenden Metallpulver verwendet werden. Ebenfalls geeignet sind metallhaltige Pulver, die entsprechend der Lehren der kanadischen Patentschrift 11 55 967 oder der DE-PS 38 06 515 hergestellt wurden und die notwendigen Zusatzelemente völlig oder zum Teil enthalten.

Die keramischen Substrate mit den durch das Auftragen der Pulver auf die klebrigen Oberflächenbereiche entstandenen Pulverbildern werden in üblicher Weise gebrannt. Dabei werden die zumindest zeitweise klebrigen Schichten durch Verdampfen oder durch Oxidation entfernt und gleichzeitig die Pulverbilder zu den gewünschten Leiterbahnzügen gesintert.

Nach dem erfindungsgemäßen Verfahren hergestellte Leiterbahnmuster haben einen geringen Gehalt an Fremdmetallen und kommen daher mit ihrer spezifischen Leitfähigkeit den reinen kompakten Metallen sehr nahe. Da sie leicht mit größerer Dicke als Dünnfilmmuster erzeugt werden können, sind sie diesen in der Leitfähigkeit überlegen. Sie besitzen eine glänzende Oberfläche, sehr gleichmäßige Begrenzungslinien und zeigen auch bei Breiten unter 20 $\mu$m keine Unterbrechungen. Ihre Haftung am Substrat ist sehr stark und gleichmäßig, sodaß die Häufigkeit von Haftungsfehlern drastisch vermindert ist.

Die zur Steuerung des Sinterns und der Haftung erforderlichen Zusatzelemente können vollständig in

3

der Beschichtung des Substrats untergebracht werden. So ist es möglich, zum Tonen der klebrigen Muster reine Metallpulver zu verwenden, die keiner besonderen Vorbehandlung unterzogen worden sind. Da solche Pulver handelsüblich sind, wird der Prozeß gegenüber dem Stand der Technik sehr vereinfacht. In diesem Fall ergibt sich als weiterer Vorteil, daß das Tonerpulver im Verlauf des Gebrauchs in seiner Zusammensetzung konstant bleibt, da es keine Kompo nenten enthält, die selektiv an der klebrigen Oberfläche haften könnten.

Die Erfindung läßt sich zur Herstellung von metallischen Mustern auf wärmebeständigen, insbesondere keramischen Substraten anwenden, wie sie beispielsweise für gedruckte Schaltungen, Hybridschaltungen sowie für optische Bauteile und für dekorative Zwecke benötigt werden.

Ausführungsbeispiel:

5 x 5 cm große Plättchen aus Aluminiumoxid wurden in einem Schleuderbeschichtungsgerät bei 1000 U/min mit einer der folgenden Lösungen beschichtet und mittels einer Infrarotquelle zum Trocknen auf etwa 200 C aufgeheizt. Ein Teil dieser Plättchen wurde zusätzlich bei 900 C 10 min lang geglüht und wieder abgekühlt.

1. 1 Gewichtsteil Wismut(III)nitrat in 9 Gewichtsteilen Essigsäure.

2. 1 Gewichtsteil Borax (Natriumtetraboratdekahydrat) in 9 Gewichtsteilen Wasser.

Auf die so behandelten Substrate wurde eine Lösung von je 3,25 g des Dimethyl- und des Diethylesters der 2,6-Dimethyl-4-(2′-nitrophenyl)-1,4-dihydropyridin-3,5-dicarbonsäure in 100 ml Methylethylketon aufgetragen und getrocknet, so daß die trockene lichtempfindliche Schicht etwa 1,5 $\mu$m dick war. Auf diese Schicht wurde mit einer Quecksilberdampflampe ein Testmuster aufbelichtet, welches Leiterbahnen von 25 $\mu$m Breite und quadratische Flächen von 2x2 mm für die Bondprüfung aufwies. Auf der belichteten Schicht wurde mit reinem Goldpulver von 1,5 $\mu$m mittlerer Teilchengröße ein Pulverbild mit einem Flächenauftragsgewicht von etwa 5 mg/cm2 nach dem Verfahren der DE-PS 37 36 391 erzeugt. Danach wurden die Plättchen bei 900 oC 10 min gebrannt. Die mikroskopische Untersuchung der Probeplättchen zeigte Leiterbahnen mit glatten Rändern.

Die Adhäsion der Goldschicht auf dem Substrat wurde bestimmt, indem 37,5 $\mu$m starke Golddrähte auf die 2x2 mm großen Flächen aufgebondet und die zum Abreißen notwendigen Kräfte bestimmt wurden. Dieser Versuch wurde etwa hundertmal wiederholt und der Anteil der Versuche ermittelt, bei denen die Abreißkraft kleiner als 10 cN war. Für die Ermittlung des spezifischen Widerstandes der Leiterbahnen wurde deren Querschnitt aus der durch Wägung bestimmten aufgetragenen Pulvermenge berechnet. Die Prüfergebnisse sind in untenstehender Tabelle aufgeführt.

Vergleichsversuch A:

Bei diesem Versuch wurden die Substratplättchen nicht mit Lösungen von Salzen der Zusatzelemente beschichtet. Die klebrigen Muster wurden mit einem Pulver behandelt, das aus 62,5 mg Wismutoxid, 31,3 mg Cadmiumoxid, 6,3 mg Kupfer-(I)-oxid, 8,6 mg Rhodium-(III)-oxid und 5 g Goldpulver nach dem im Beispiel 1 der DE-PS 38 06 515 beschriebenen Verfahren hergestellt worden war. Im übrigen wurde wie beim Anwendungsbeispiel gearbeitet.

Vergleichsversuch B:

Es wurde wie beim Vergleichsversuch A gearbeitet, jedoch wurde das Pulver aus 5 g Goldpulver sowie einer Lösung von 104 mg Wismut-(III)-acetat in 5 ml Essigsäure und einer Lösung von 56,6 mg Cadmiumacetat, 16,2 mg Kupfer-(III)-acetat und 19,0 mg Rhodium-(III)-acetat in 5 ml Wasser nach dem im Beispiel 2 der DE-PS 38 06 515 beschriebenen Verfahren hergestellt.

Tabelle

| Probe | Wärmebehandlung (°C) | Abrisse <10 cN | Spezifischer Widerstand ($\mu\Omega$cm) |
|---|---|---|---|
| 1. | 200 | 0 | 2,8 |
| 1 | 900 | 44 | 2,8 |
| 2 | 200 | 0 | 2,8 |
| 2 | 900 | 100 | 2,8 |
| A | - | 27 | 4,8 |
| B | - | 0 | 3,5 |

**Ansprüche**

1. Verfahren zur Herstellung von elektrisch leitfähigen Mustern nach dem Pulververfahren unter Verwendung einer wenigstens zeitweise klebrigen Schicht und eines metallhaltigen Pulvers, wobei das Pulverbild durch Wärmebehandlung in Gegenwart von Zusatzelementen, welche die Haftung der Leiterbahnen am Substrat und das Sinterverhalten des Leitmetalls steuern, oder von Verbindungen solcher Zusatzelemente in ein Leiterbahnmuster umgewandelt wird,
dadurch gekennzeichnet, daß
- das Substrat vor dem Auftragen der wenigstens zeitweise klebrigen Schicht mit einer Lösung von Salzen, welche die Zusatzelemente enthalten, beschichtet,
- getrocknet und
- nach dem Trocknen auf eine Temperatur erwärmt wird, die niedriger ist als die zur Bildung der Oxide der Zusatzelemente aus den Salzen erforderliche Temperatur.

2. Verfahren nach Anspruch 1,
dadurch gekennzeichnet, daß
die wenigstens zeitweise klebrige Schicht eine lichtempfindliche Schicht ist, deren Klebrigkeit sich bei Belichtung ändert.

3. Verfahren nach Anspruch 2,
dadurch gekennzeichnet, daß
die lichtempfindliche Schicht Dihydropyridinverbindungen enthält.

4. Verfahren nach einem der Ansprüche 1 bis 3,
dadurch gekennzeichnet, daß
das metallische Muster aus Gold, Silber, Palladium, Platin, Kupfer oder aus Legierungen zweier oder mehrerer dieser Metalle gebildet wird.

5. Verfahren nach einem der Ansprüche 1 bis 4,
dadurch gekennzeichnet, daß
als Zusatzelemente Blei, Rhodium, Nickel, Aluminium, Cadmium, Kupfer, Indium, Bor und/oder Wismut verwendet werden.

6. Verfahren nach einem der Ansprüche 1 bis 5,
dadurch gekennzeichnet, daß
die Lösung der Salze als Lösungsmittel Wasser und/oder andere polare Lösungsmittel enthält.

7. Verfahren nach einem der Ansprüche 1 bis 6,
dadurch gekennzeichnet, daß
die Salze der Zusatzelemente Acetate, Nitrate, Borate und/oder Chloride sind.

8. Verfahren nach einem der Ansprüche 1 bis 7,
dadurch gekennzeichnet, daß
Salze und Temperatur der Wärmebehandlung nach dem Trocknen so ausgewählt werden, daß auf dem Substrat ein kontinuierlicher homogener glasartiger Film aus den Verbindungen der Zusatzelemente entsteht.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 224 137 (DU PONT)<br>* Seite 2, Zeilen 10-29; Ansprüche 1,2,8,9 *<br>--- | 1-3 | H 05 K 3/10<br>G 03 F 7/28 |
| A | EP-A-0 035 187 (DU PONT)<br>* Ansprüche 1,2 *<br>--- | 1-4,8 | |
| A | DE-A-3 541 427 (DU PONT)<br>* Ansprüche 1,9-11,13 *<br>--- | 1-4 | |
| A | EP-A-0 200 110 (HITACHI)<br>* Ansprüche 7-9 *<br>--- | 1,2 | |
| A,D | DE-A-3 429 615 (DU PONT)<br>* Seite 3, Zeile 13 - Seite 5, Zeile 10 *<br>--- | 1-4 | |
| A,D | CA-A-1 155 967 (NORTHERN TELECOM)<br>* Ansprüche 1-18 *<br>----- | 1,8 | |

**RECHERCHIERTE SACHGEBIETE (Int. Cl.5)**

H 05 K 3/00
G 03 F 7/00

Der vorliegende Recherchenbericht wurde für alle Patentansprüche erstellt

| Recherchenort | Abschlußdatum der Recherche | Prüfer |
|---|---|---|
| BERLIN | 26-07-1990 | HAHN G |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0401)